# EUROPÄISCHE PATENTANMELDUNG

(11) **EP 0 788 150 A2**
(43) Veröffentlichungstag der Anmeldung: **06.08.1997**
(21) Anmeldenummer: 96120188.6
(22) Anmeldetag: 16.12.1996
(51) Int. Cl.: H01L 21/60, H01L 23/492

(54) **Verfahren zum Löten eines Halbleiterkörpers auf eine metallene Trägerplatte**

(30) Priorität: 01.02.1996 DE 19603654
(71) Anmelder: SIEMENS AKTIENGESELLSCHAFT, 80333 München (DE)
(72) Erfinder: Laska, Thomas, 80796 München (DE); Strack, Helmut, Dr., 80804 München (DE)

(57) **Zusammenfassung**

Die Rückseite eines Silizium-Halbleiterkörpers (1) wird mit einer metallenen Trägerplatte (2) über eine Folge von Metallschichten verlötet, die eine Nickelschicht (5) enthält. Die Nickelschichtdicke kaum dadurch verringert werden, daß dem Lötmaterial ein Prozentsatz an Nickel zugegeben wird, der der Löslichkeit von Nickel in dem Lötmaterial bei den üblichen Löttemperaturen (250° C bis 400° C) entspricht.

## Beschreibung

Die Erfindung betrifft ein Verfahren zum Löten eines aus Silizium bestehenden Halbleiterkörpers auf eine metallene Trägerplatte, wobei auf den Halbleiterkörper eine Folge von Metallschichten aufgebracht wird, die vor dem Löten ausgehend vom Silizium in Richtung zur Trägerplatte eine Nickelschicht und eine Silberschicht enthält, und zwischen die Silberschicht und die Trägerplatte ein Lötmaterial gebracht wird, mit welchem der Halbleiterkörper und die Trägerplatte verlötet wird. Eine Vielzahl von Halbleiterbauelementen, insbesondere Leistungs-Halbleiterbauelemente, werden bei der Montage auf metallene Trägerplatten gelötet.

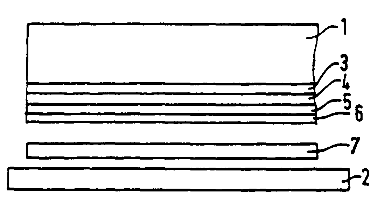

Die Folge von Metallschichten enthält, wie in der Figur dargestellt, eine Aluminiumschicht, die auf einem Silizium-Halbleiterkörper sitzt. Die Aluminiumschicht haftet gut auf Silizium und bildet insbesondere mit p-dotiertem Silizium einen einwandfreien ohmschen Kontakt. Auf der Aluminiumschicht sitzt eine Rückseitenbarriereschicht, aus Titan oder Chrom, die als Haftvermittler und Diffusionssperre zwischen einer auf der Rückseitenbarriereschicht sitzenden Nickelschicht und der Aluminiumschicht dient. Auf die Nickelschicht wird nach dem Stand der Technik eine als Oxidationsschutz dienende Silberschicht aufgebracht.

Bei dem allgemein bekannten Lötverfahren nach dem Stand der Technik wird dann zwischen die so metallisierte Halbleiterkörperrückseite und der metallenen Trägerplatte 2 meist ein aus hauptsächlich Zinn bestehendes Lötplättchen gelegt. Durch Erwärmung auf Temperaturen von oberhalb von ca. 250° C wird dann die eigentliche Lötverbindung hergestellt, die bekannterweise zwischen dem Lot (Zinn) und dem Nickel stattfindet. Beim Lötvorgang schmilzt die zwischen die Trägerplatte und die Silberschicht des Halbleiterkörpers eingelegte Lotschicht auf, die Silberschicht wird dabei aufgelöst und die dann folgende Nickelschicht wird von dem verwendeten Lötmaterial angelöst.

Dieses Anlösen der Nickelschicht durch das beim Lötvorgang verwendete Zinn hat sich aber als sehr nachteilig erwiesen. Dicke Nickelschichten führen wegen der unterschiedlichen thermischen Ausdehnungskoeffizienten von Nickel und dem Silizium-Halbleiterkörper zu starken Verbiegungen, die wiederum zu einem schwierigen 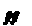 Handling" der Wafer, zu vermehrten Kassetten-Positionierfehlern und erhöhter Bruchgefahr führen. Zu dünne Nickelschichten wiederum ergeben, daß sich die Nickelschicht vollständig im Lotmaterial löst und damit der gesamte Lötprozeß instabil wird, d.h. daß z.B. der Silizium-Halbleiterkörper sich von der metallenen Trägerplatte löst oder aber sich das Lot bis in den Halbleiterkörper 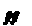 hineinfrißt".

Aufgabe der vorliegenden Erfindung ist es daher, das eingangs erwähnte Lötverfahren dahingehend zu verbessern, daß die verwendeten Nickelschichten in ihrer Dicke stark reduziert werden können, ohne daß sich die Nickelschicht vollständig im Lot auflösen kann.

Erfindungsgemäß wird diese Aufgabe mit einem Verfahren gelöst, welches dadurch gekennzeichnet ist, daß dem Lotmaterial ein Prozentsatz an Nickel zugegeben wird, der der Löslichkeit von Nickel in dem Lötmaterial bei den üblichen Löttemperaturen entspricht.

Vorzugsweise wird bei der Verwendung von Zinn als Lötmaterial diesem ein Zusatz von 0,5 bis etwa 5 % Nickel beigegeben, wobei ein Nickelzusatz von etwa 1 % besonders geeignet ist, da bei den üblichen Löttemperaturen (250° C bis 400° C) nur ungefähr etwa 1 % Nickel durch das Zinn aufgelöst wird.

In der Figur ist die Schichtfolge der Metalle vor dem Verlöten gezeigt. Die Folge von Metallschichten enthält eine Aluminiumschicht 3, die auf einem Silizium-Halbleiterkörper 1 sitzt. Die Aluminiumschicht haftet gut auf Silizium und bildet insbesondere mit p-dotiertem Silizium einen einwandfreien ohmschen Kontakt. Auf der Aluminiumschicht 3 sitzt eine Titanschicht 4, die als Haftvermittler und Diffusionssperre zwischen einer auf der Titanschicht 4 sitzenden Nickelschicht 5 und der Aluminiumschicht 3 dient. Auf die Nickelschicht 5 wird direkt eine Silberschicht 6 aufgebracht, die als Oxidationsschutz für die Nickelschicht dient. Es kann aber auch zwischen die Silberschicht und die Nickelschicht eine als Haftvermittler dienende dünne Titanschicht eingebracht werden (nicht gezeigt), welche ein Ablösen der Silberschicht vermeidet. Beim Lötvorgang schmilzt das zwischen die Trägerplatte 2 und die Silberschicht 6 des Halbleiterkörpers eingelegte Lötmaterial 7, das hier Zinn mit einem 1 %-igen Nickelzusatz ist, auf, und die Silberschicht 6 wird aufgelöst. Die dann folgende Nickelschicht 5 wird nur wenig angelöst, da nach dem Phasendiagramm für Zinn/Nickel bei den üblichen Löttemperaturen (250° C bis 400° C) nur etwa 1 % Nickel durch das Zinn aufgelöst werden kann und das Zinn durch den erfindungsgemäßen Nickelzusatz schon gesättigt ist. Auch mit vergleichsweise dünnen Nickelschichten (kleiner 400 nm) auf der Chiprückseite sind deshalb gute Lötverbindungen möglich. Die beschriebene Schichtenfolge ergibt einen mechanisch und elektrisch stabilen Kontakt.

Die Erfindung ist zwar für einen Kontakt mit einer Schichtfolge Al/Ti/Ni/Ag beschrieben worden. Sie ist jedoch selbstverständlich auch für Schichtfolgen anwendbar, bei der zwischen der Nickelschicht 5 und dem Halbleiterkörper 1 andere Metallschichten vorgesehen sind und/oder eine andere Oxidationsschutzschicht verwendet wird. Wesentlich ist, daß beim Löten ein nickelhaltiges Lotmaterial verwendet wird, so daß die Nickelschicht nicht oder gegenüber dem Stand der Technik nur geringfügig angelöst wird.

## Patentansprüche

1. Verfahren zum Löten eines aus Silizium bestehenden Halbleiterkörpers (1) auf eine metallene Trägerplatte (2), wobei auf den Halbleiterkörper eine Folge von Metallschichten aufgebracht wird, die vor dem Löten ausgehend vom Silizium in Richtung zur Trägerplatte eine Nickelschicht (5) und eine Silberschicht (6) enthält, und zwischen die Silberschicht und die Trägerplatte ein Lötmaterial (7) gebracht wird, mit welchem der Halbleiterkörper und die Trägerplatte verlötet wird, **dadurch gekennzeichnet,** daß dem Lötmaterial (7) ein Prozentsatz an Nickel zugegeben wird, der der Löslichkeit von Nickel in dem Lötmaterial bei den üblichen Löttemperaturen entspricht.

2. Verfahren nach Anspruch 1,
**dadurch gekennzeichnet,** daß als Lötmaterial Zinn mit einem Zusatz von 0,5 bis etwa 5 % Nickel verwendet wird.

3. Verfahren nach Anspruch 2,
**dadurch gekennzeichnet,** daß der Nickelzusatz etwa 1 % beträgt.

4. Aus Silizium bestehender Halbleiterkörper (1) zur Durchführung des Verfahrens nach einem der Ansprüche 1 bis 3, der mit einer metallenen Trägerplatte (2) über eine Folge von Metallschichten verlötbar ist, die vor dem Löten ausgehend vom Silizium in Richtung zur Trägerplatte eine Nickelschicht (5) und eine Silberschicht (6) enthält,
**gekennzeichnet durch** eine Dicke der Nickelschicht (5) von weniger als 400 nm.
